# EUROPEAN PATENT SPECIFICATION

(11) **EP 1 008 670 B1**
(45) Date of publication and mention of the grant of the patent: **11.08.2004**
(21) Application number: 99123785.0
(22) Date of filing: 30.11.1999
(51) Int. Cl.: C23C 14/34, G11B 7/26, C04B 35/547

(54) **A method of manufacturing a sputtering target**
Ein Verfahren zur Herstellung eines Sputtertargets
Un procédé pour la fabrication d'une cible de pulvérisation

(30) Priority: 07.12.1998 JP 34692198; 29.09.1999 JP 27635199
(43) Date of publication of application: 14.06.2000
(73) Proprietor: Nikko Materials Company, Limited, Tokyo 105-8407 (JP)
(72) Inventor: Ohhashi, Tateo Isohara Plant of Nikko Mat. Co. Ltd, Ibaraki-Ken, 319-1535 (JP); Kuwano, Katsuo Isohara Plant of Nikko Mat. Co. Ltd, Ibaraki-Ken, 319-1535 (JP); Takami, Hideo Isohara Plant of Nikko Mat. Co. Ltd, Ibaraki-Ken, 319-1535 (JP)
(74) Representative: Meddle, Alan Leonard

(56) References cited:
- EP-A- 0 872 571
- PATENT ABSTRACTS OF JAPAN vol. 1999, no. 01, 29 January 1999 (1999-01-29) & JP 10 280138 A (MITSUBISHI MATERIALS CORP), 20 October 1998 (1998-10-20)
- PATENT ABSTRACTS OF JAPAN vol. 018, no. 313 (C-1212), 15 June 1994 (1994-06-15) & JP 06 065725 A (DOWA MINING CO LTD), 8 March 1994 (1994-03-08)

## Description

### BACKGROUND OF THE INVENTION

### FIELD OF THE INVENTION

The present invention relates to a sputtering target of ZnS-SiO₂ capable of controlling formation of coarse particles during the sputtering process to form a film, the dielectric protective film produced by the aid of this target being useful for an optical disk, in particular phase-change type optical disk.

### DESCRIPTION OF THE PRIOR ART

Recently, techniques for producing high-density recording optical disks capable of recording and reading information without needing a magnetic head have been developed, and attracting attention increasingly. The optical disks fall into three general categories; for read only type, write once type and rewriting type. The phase-change type disk used for rewriting type media has been particularly attracting attention. The rewriting principles using the phase-change type optical disk are described, below.

The phase-change type optical disk is heated, when the recording thin film on the substrate is irradiated with laser beams, to cause crystallographic phase change (between amorphous and crystalline states) in the recording thin film structure for rewriting information. More concretely, information is reproduced according to changed reflectivity accompanying phase change, which changes the optical constant of the disk.

The optical disk is irradiated with laser beams, narrowed down to a diameter of 1 to several µm, to cause the phase change. In this case, for example, when laser beams having a diameter of 1 µm pass the optical disk at 10 m/s, a point on the disk is irradiated with them for 100 ns, within which the phase change and reflectivity detection must be completed.

It must be also taken into consideration that not only the phase-change recording layer but also its peripheral layers, e.g., dielectric protective layer and reflecting layer of aluminum alloy, undergo fusion/quenching cycles, when the crystallographic phase change occurs between the amorphous and crystalline states.

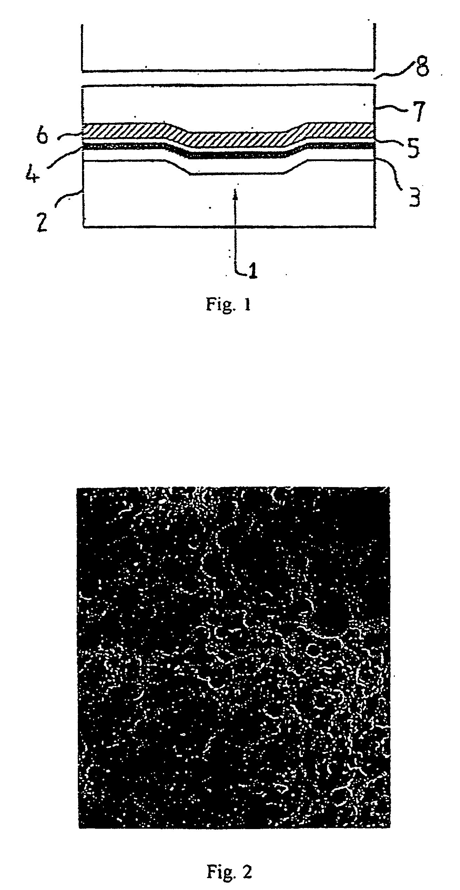

Therefore, the phase-change optical disk is designed to be of 4-layered structure, as shown in FIG. 1, with the recording thin film layer 4 of Ge-Sb-Te or the like, placed between the protective layers 3 and 5 of ZnS-SiO₂-based high-melting point dielectric, and the reflecting film 6 of aluminum alloy on the protective layer.

The reflecting layer 6 and protective layers 3 and 5 are required to have some functions, e.g., optical functions of absorbing large quantities of laser beams both for the amorphous and crystalline states of the recording layer, and a large difference in reflectivity between these states; prevention of deformation of the recording thin film 4 by moisture or heat; and controlling thermal conditions during the recording step refer to Magazine "Optics" vol.26, No.1, pp. 9 to 15).

Thus, the protective layers 3 and 5 of high-melting dielectric are required to have resistance to thermal stress resulting from heating/cooling cycles, and prevent these thermal effects from spreading to the reflecting layer and other layers. Moreover, they themselves must be thin, low in reflectivity and tough to be resistant to degradation. Therefore, the dielectric protective layer plays important roles.

The other marks shown in FIG. 1 are; 1: incidence direction of the laser beams, 2: substrate of polycarbonate or the like, 7: overcoat, and 8: adhesive layer.

The dielectric protective layer is normally produced by sputtering, where a high voltage is applied to a space of inert gas atmosphere between the substrate working as the anode and target working as the cathode, arranged to face each other, to generate an electrical field in the space. The dissociated electrons collide with the inert gas to produce plasma, and the cations in the plasma collide the target (cathode) surface, knocking on the target atoms, which fly to the opposite substrate to form a film thereon.

In the sputtering process with a target of ZnS-SiO₂ for producing a thin film, clustered coarse particles (hereinafter refer to as "particles") tend to deposit on the thin film, when the substrate is coated with the film to a certain extent. These particles are formed mainly by the following phenomena: the particles splashed during the sputtering process are deposited on walls and various devices in the sputtering chamber, and they exfoliate, when grown to a certain extent, float in the sputtering chamber and are deposited on the substrate or thin film.

The quality of the film is greatly reduced, when it is deposited with these particles. Therefore, the sputtering process is suspended when these particles are deposited on the substrate or thin film to a certain extent, and the sputtering chamber is opened to remove the deposited dust-like films in the chamber, which may be exfoliated to form the particles, from the walls and devices in the chamber.

This greatly reduces productivity. Some of the causes for such troubles have been attributed to the ZnS-SiO₂ target production step, i.e., firing of the mixed ZnS and SiO₂ powder. However, the solution was not known.

In order to provide a high strength sputtering target for forming an optical recording protective coating, PATENT ABSTRACTS OF JAPAN VOL 1999, No. 01, 29 January, 1999 and JP 10280138A (MITSUBISHI MATERIALS CORP), 20 October, 1998 disclose a sputtering target composed of a ZnS-SiO₂ sintered body with a structure in which SiO₂ composite powder obtained by coating the surface of fine SiO₂ powder with an average particle size of 10 to 100µm with a ZnS coating is uniformly dispersed in a ZnS base.

### OBJECT OF THE INVENTION

It is an object of the present invention to provide a sputtering target of ZnS-SiO₂ which greatly controls formation of the particles during the sputtering process, thereby reducing sputtering suspension to enhance productivity, by improving the SiO₂ powder for the ZnS-SiO₂ target. This is the result of drastically reviewing the sputtering target production step.

### SUMMARY OF THE INVENTION

The inventors of the present invention according to claim 1 have developed a new sputtering target of ZnS-SiO₂ after the extensive studies for solving the problems. The new sputtering target of ZnS-SiO₂ is produced by using spherical SiO₂ powder, having an average grain size which is less than 10µm and not less than 1µm, in place of the conventional SiO₂ powder having an average grain size of 20 to 30µm, mixing the SiO₂ powder with ZnS powder, and sintering the mixed powder in an HIP or the like.

The sputtering target is found greatly to control formation of the particles, to improve uniformity of the coating film, and to give a dielectric protective film (layer) at high repeatability under stable production conditions.

Based on the above results, the present invention thus provides a method of manufacturing a ZnS-SiO₂ sputtering target, characterized in that said target is manufactured by sintering a mixed powder of spherical SiO₂ powder and ZnS powder, the average grain size of said SiO₂ powder being less than 10µm and not less than 1µm.

Preferably, the ratio of the maximum to the minimum diameters of the spherical grains is 1.2 or less as defined in Claim 2.

### BRIEF DESCRIPTION OF THE DRAWINGS

FIG. 1 is a cross-sectional view of a recording thin film layer structure.
FIG. 2 presents a scanning electron microscope (SEM) image showing the whole structure of the sintered ZnS-SiO₂ target prepared by a method embodying the invention (EMBODIMENT).
FIG. 3 presents a SEM image of the Zn section of the target prepared by EMBODIMENT.
FIG. 4 presents a SEM image of the S section of the target prepared by EMBODIMENT.
FIG. 5 presents a SEM image of the Si section of the target prepared by EMBODIMENT.
FIG. 6 presents a SEM image of the O section of the target prepared by EMBODIMENT.
FIG. 7 presents a SEM image showing the structure of the sintered ZnS-SiO₂ of the target prepared by COMPARATIVE EXAMPLE 1.
FIG. 8 presents a SEM image of the Zn section of the target prepared by COMPARATIVE EXAMPLE 1.
FIG. 9 presents a SEM image of the S section of the target prepared by COMPARATIVE EXAMPLE 1.
FIG. 10 presents a SEM image of the Si section of the target prepared by COMPARATIVE EXAMPLE 1.
FIG. 11 presents a SEM image of the O section of the target prepared by COMPARATIVE EXAMPLE 1.

### DETAILED DESCRIPTION OF THE PREFERRED EMBODIMENTS

ZnS and SiO₂ as the starting materials for the sputtering target of the present invention will not react with each other at 1000°C or less, as thermodynamics indicate, and ZnS itself sublimates at 1100°C or more. It is therefore considered that the ZnS-SiO₂ target prepared by sintering is in the form of a dense mixture.

As mentioned above, the conventional method for producing a sputtering target of ZnS-SiO₂ uses SiO₂ powder having an average grain size of 20 to 30 µm for the mixture to be sintered. It was not anticipated that properties of the SiO₂ powder and mixed conditions with ZnS at this stage of process might cause formation of the particles.

It is found that the target with spherical SiO₂ powder having an average grain size of 1 to 10 µm, sintered together with ZnS powder, unexpectedly greatly controls formation of the coarse particles during the sputtering process. Improved property of the SiO₂ powder in the target and improved mixture conditions (with the SiO₂ powder dispersed more uniformly in the ZnS powder) are considered to prevent the atomic or molecular particles or a small quantity of agglomerates thereof thrown out of the target from flying in unplanned or undesired paths, and also to secure uniform and stable sputtering.

Controlled formation of the particles is also considered to result from use of the spherical SiO₂ powder, which decreases surface area of the particles and increases density of the target.

As discussed above, controlled size of the SiO₂ powder improve their dispersibility, realizing a very good sputtering process that produces much reduced quantities of the particles.

Because the spherical SiO₂ powder has a smaller specific surface than other shapes of the same grain size, increasing target density. It brings about another advantage of reduced pore between the ZnS and SiO₂ powder in the target, resulting from insufficient sintering.

Controlled formation of the particles reduces necessity of sputtering suspension and time-consuming cleaning of the sputtering chamber inside, thereby greatly improving productivity as compared with the prior arts.

### EMBODIMENTS AND COMPARATIVE EXAMPLES

The present invention is described based on EMBODIMENTS and COMPARATIVE EXAMPLES. It is to be understood that EMBODIMENT is to provide one of the preferred embodiments and not to limit the present invention. The present invention is limited only by the claims described in this specification, and involves many variations other than the sputtering target prepared by EMBODIMENT.

### (EMBODIMENT)

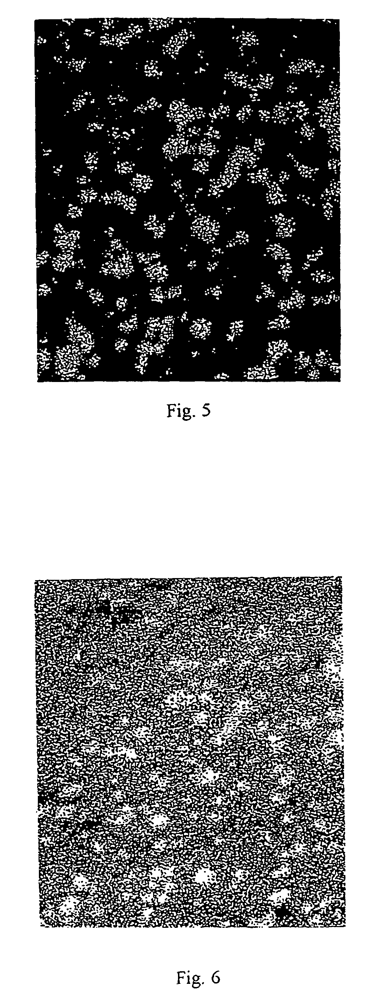

A mixture of spherical SiO₂ powder having an average grain size of 6 µm and ZnS powder having an average grain size of 5 µm (molar ratio of 20:80) was hot-pressed in an argon atmosphere under the conditions of 1000°C and 14.7 MPa (150 Kg-f/cm²). The ZnS-SiO₂ target thus prepared had a density of 3.4 g/cm³. The microscopic analysis revealed that the target had a uniform texture of the crystal grains, as shown in FIGS. 2 to 6.

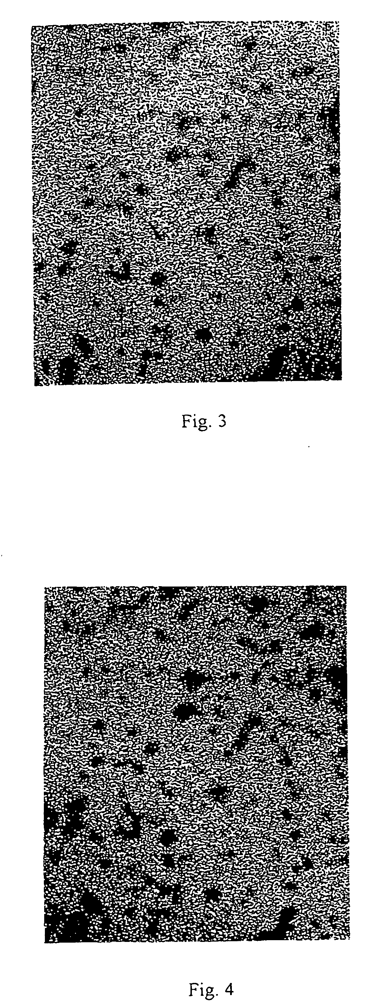

FIG. 2 shows a scanning electron microscope (SEM) image of the sample, and FIGS. 3 to 6 SEM images of the Zn, S, Si and O sections, respectively.

The sputtering was conducted using the ZnS-SiO₂ target, to see number of the coated substrates (media) produced before production was suspended on account of an excessive quantity of the particles deposited on the film, which required cleaning of the inner walls and devices within the sputtering chamber. It was around 3,500 pieces of media. This translates into at least 40% higher productivity than those observed in COMPARATIVE EXAMPLES described below.

### (COMPARATIVE EXAMPLE 1)

A mixture of as-pulverized, angular SiO₂ powder having an average grain size of 20 to 30 µm and ZnS powder having an average grain size of 5 µm (molar ratio of 20:80) was hot-pressed in an argon atmosphere under the conditions of 1000°C and 14.7 MPa (150 Kg-f/cm²). The ZnS-SiO₂ target thus prepared had a density of 3.4 g/cm³.

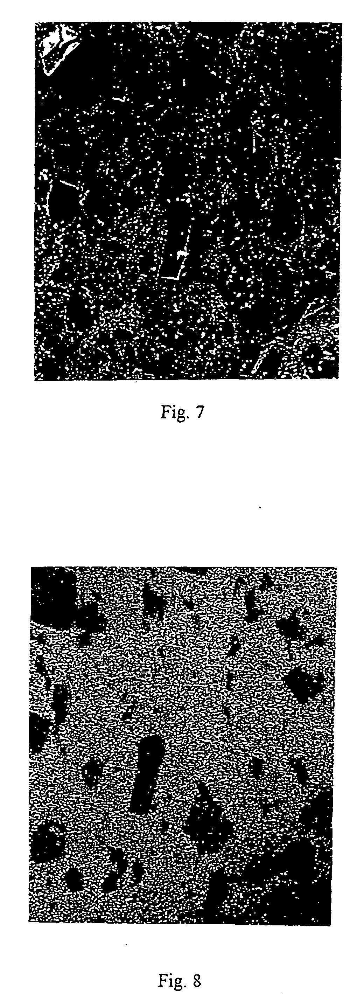

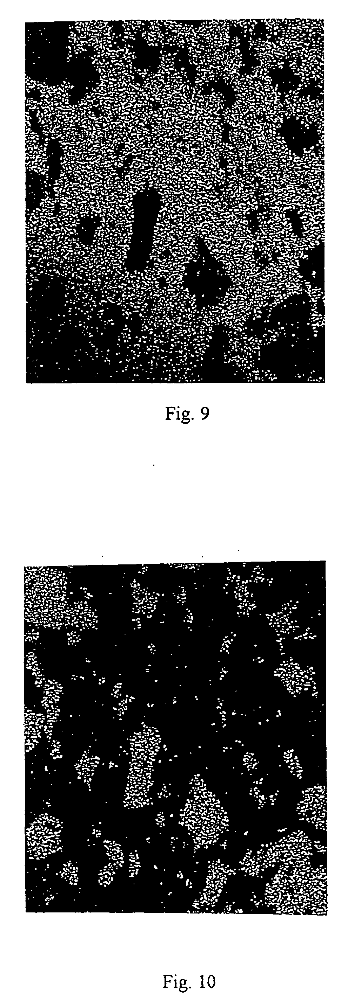

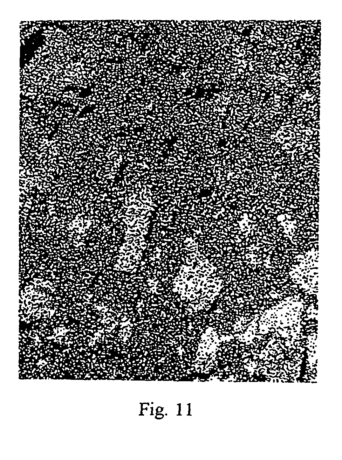

The microscopic analysis revealed that the ZnS-SiO₂ target had a texture with distorted, coarse grains distributed irregularly, as shown in FIGS. 7 to 11.

FIG. 7 shows an SEM image of the sample, and FIGS. 8 to 11 SEM images of the Zn, S, Si and O sections, respectively.

The sputtering was conducted using the ZnS-SiO₂ target, to see number of the media produced before production was suspended on account of an excessive quantity of particles deposited on the film, which required cleaning of the inner walls and devices within the sputter chamber. It was around 2,500 pieces of media. This translates into at least 40% lower productivity than that observed in EMBODIMENT.

### (COMPARATIVE EXAMPLE 2)

A mixture of spherical SiO₂ powder having an average grain size of 0.5 µm and ZnS powder having an average grain size of 5 µm (molar ratio of 20:80) was hot-pressed in an argon atmosphere under the conditions of 1000°C and 14.7 MPa (150 Kg-f/cm²). The ZnS-SiO₂ target thus prepared had a density of 3.2 g/cm³.

The sputtering was conducted using the ZnS-SiO₂ target, to see number of the media produced before production was suspended on account of an excessive quantity of the particles deposited on the film, which required cleaning of the inner walls and devices within the sputter chamber. It was 2,500 pieces of media. This translates into approximately 40% lower productivity than that observed in EMBODIMENT.

### (COMPARATIVE EXAMPLE 3)

A mixture of as-pulverized, angular SiO₂ powder having an average grain size of 5 µm and ZnS powder having an average grain size of 5 µm (molar ratio of 20:80) was hot-pressed in an argon atmosphere under the conditions of 1000°C and 14.7 MPa (150 Kg-f/cm²). The ZnS-SiO₂ target thus prepared had a density of 3.3 g/cm³.

The sputtering was conducted using the ZnS-SiO₂ target, to see number of the media produced before production was suspended on account of an excessive quantity of the particles deposited on the film, which required cleaning of the inner walls and devices within the sputtering chamber. It was around 2,500 pieces of media. This translates into approximately 40% lower productivity than that observed in EMBODIMENT.

Table 1 shows the target characteristics (density) and number of media produced before the sputtering chamber must be cleaned, observed in EMBODIMENT and COMPARATIVE EXAMPLES 1 to 3.

As apparent from Table 1, in EMBODIMENT of the present invention a density is high, and products efficiency is high. On the other hand, in COMPARATIVE EXAMPLES that are outside of the scope of the present invention, it is observed that the density is lower and the production efficiency is extraordinarily lowered. Furthermore, it is also observed that the rate of generating crack during service is more frequent.

**[Table 1]**

| | EMBODIMENT 1 | COMPARATIVE EXAMPLE 1 | COMPARATIVE EXAMPLE 2 | COMPARATIVE EXAMPLE 3 |
|---|---|---|---|---|
| SiO₂ grain (average size and shape) | 6 µm spherical | 20 µm polygonal (ruptured form) | 0.5 µm spherical | 5 µm polygonal (ruptured form) |
| Target characteristic (density) | 3.4 g/cm³ | 3.4 g/cm³ | 3.2 g/cm³ | 3.3 g/cm³ |
| Number of media produced before the chamber must be cleaned | 3500 pieces | 2500 pieces | 2500 pieces | 2500 pieces |

The sputtering target of ZnS-SiO₂ of the present invention is produced by sintering a mixture of SiO₂ and ZnS powder, where spherical SiO₂ powder having an average grain size of 1 to 10 µm replaces SiO₂ powder having larger grain size used by the conventional method. This target exhibits excellent characteristics of greatly controlling formation of the particles during the sputtering process, giving media at high repeatability under stable production conditions.

## Claims

1. A method of manufacturing a ZnS-SiO₂ sputtering target, **characterized in that** said target is manufactured by sintering a completely mixed powder of spherical SiO₂ powder and ZnS powder, the average grain size of said SiO₂ powder being less than 10µm but not less than 1µm.

2. A method of manufacturing a sputtering target according to Claim 1, wherein the maximum diameter of each of the spherical grains is 1.2 times or less than 1.2 times the minimum diameter of the grains.

## Patentansprüche

1. Ein Verfahren zur Herstellung eines ZnS-SiO₂-Sputtertargets, **dadurch gekennzeichnet, dass** das Target durch Sintern eines vollständig gemischten Pulvers aus sphärischem SiO₂-Pulver und ZnS-Pulver hergestellt wird, wobei die mittlere Korngröße von genanntem SiO₂-Pulver kleiner als 10µm, aber nicht kleiner als 1µm ist.

2. Verfahren zur Herstellung eines Sputtertargets nach Anspruch 1, **dadurch gekennzeichnet, dass** der maximale Durchmesser jedes sphärischen Korns das 1,2-fache oder weniger als das 1,2-fache des minimalen Durchmessers der Körner beträgt.

## Revendications

1. Procédé de fabrication d'une cible de pulvérisation de ZnS-SiO₂, **caractérisée en ce que** ladite cible est fabriquée par frittage d'une poudre complètement mélangée de poudre sphérique de SiO₂ et de poudre de ZnS, la taille de grain moyenne de ladite poudre de SiO₂ étant inférieure à 10 µm mais n'étant pas inférieure à 1 µm.

2. Procédé de fabrication d'une cible de pulvérisation selon la revendication 1, selon lequel le diamètre maximun de chacun des grains sphériques est 1,2 fois ou n'est pas inférieure à 1,2 fois le diamètre minimum des grains.
